# EUROPÄISCHE PATENTSCHRIFT

(11) **EP 3 593 152 B1**
(45) Veröffentlichungstag und Bekanntmachung des Hinweises auf die Patenterteilung: **21.01.2026**
(21) Anmeldenummer: 18706996.8
(22) Anmeldetag: 20.02.2018
(51) Int. Cl.: G01R 15/20, G01R 1/18, H01R 13/66

(54) **MODULARER STECKVERBINDER MIT STROMSENSORANORDNUNG UND STROMMESSVERFAHREN**
MODULAR CONNECTOR WITH CURRENT SENSOR ARRANGEMENT AND CURRENT MEASUREMENT METHOD
CONNECTEUR MODULAIRE AVEC AGENCEMENT DE CAPTEURS DE COURANT ET PROCÉDÉ DE MESURE DE COURANT

(30) Priorität: 08.03.2017 DE 102017104864
(43) Veröffentlichungstag der Anmeldung: 15.01.2020
(73) Patentinhaber: HARTING Electric Stiftung & Co. KG, 32339 Espelkamp (DE)
(72) Erfinder: KROPIEWNICKI, Norbert, 33619 Bielefeld (DE); KIRSCHT, Lukas, 46459 Rees (DE)
(74) Vertreter: Eisenführ Speiser
(86) Internationale Anmeldenummer: PCT/EP2018/054066
(87) Internationale Veröffentlichungsnummer: WO 2018/162216

(56) Entgegenhaltungen:
- EP-A2- 0 597 404
- WO-A1-2016/148022
- WO-A1-94/27157
- DE-A1- 102014 215 809
- US-A1- 2012 319 676
- US-A1- 2015 233 980

## Beschreibung

Die vorliegende Erfindung betrifft das Gebiet der Strommessung in einem Steckverbinder und insbesondere eine Stromsensoranordnung zur Messung eines jeweiligen Stromflusses durch elektrische Kontakte oder Kontaktleitungen in einem Steckverbinder und Verfahren im Zusammenhang mit der Messung eines jeweiligen Stromflusses durch elektrische Kontakte oder Kontaktleitungen in einem Steckverbinder.

WO 2016/148022 A1 offenbart einen elektrischen Stromsensor vorgesehen, der Messfehler aufgrund der Wirkung von elektrischer Strom, der in einem anderen Leiter neben dem Leiter fließt, in dem der zu messende elektrische Strom fließt, unterdrücken kann und der das Frequenzband des elektrischen Stroms erweitern kann, der gemessen werden kann. Ein Magnetsensor ist auf einer ersten imaginären Linie positioniert, die in Breitenrichtung durch die Mitte zweier magnetischer Abschirmungen verläuft und senkrecht zu einer imaginären Ebene ist, so dass der Erfassungswert des Magnetsensors weniger von einem externen Magnetfeld beeinflusst wird. Die erste imaginäre Linie, die in Breitenrichtung durch die Mitte der magnetischen Abschirmungen verläuft, und die Mitte eines Leiters in Breitenrichtung mit einem Schnittpunkt mit der ersten imaginären Linie sind um einen Abstand voneinander versetzt. und daher sind, selbst wenn der Abstand von der Mitte des Leiters in der Breitenrichtung zum elektrischen Stromsensor klein ist, die Frequenzeigenschaften der Erfassungsempfindlichkeit des magnetischen Sensors in Bezug auf die Frequenz des elektrischen Stroms, der gemessen werden kann, auf der Hochpassseite verbessert werden.

WO 94/27157 A1 betrifft einen Stromwandler, der auf der Messung der magnetischen Flussdichte und einem Verfahren zu deren Kalibrierung basiert. Der Wandler umfasst eine Rahmenstruktur, einen im Wesentlichen ringförmigen, an die Rahmenstruktur angepassten Magnetkreis, dessen ringförmige Form einen Spalt aufweist, um einen Luftspalt zu bilden und den magnetischen Fluss auf den Luftspalt zu konzentrieren, wobei der ringförmige Magnetkreis eine Öffnung enthält, durch die der zu messende Stromleiter geführt werden kann, wobei eine Hall-Effekt-Vorrichtung in dem Luftspalt eingesetzt werden kann, und einer elektromagnetischen Abschirmstruktur, die die Rahmenstruktur umgibt, um zu verhindern, dass externe Interferenzfelder die Hall-Effekt-Vorrichtung beeinflussen. Gemäß der WO 94/27157 A1 besteht die elektromagnetische Abschirmstruktur aus einem Material, das im Wesentlichen dem des Magnetkreises ähnlich ist, und sowohl der Magnetkreis als auch die Rahmenstruktur sind so geformt, dass sie entweder einen geraden Stromleiter oder eine Wicklungsstruktur aufnehmen können, mit der die Strommessempfindlichkeit multipliziert werden kann.

US 2012/0319676 A1 offenbart einen abnehmbaren Stromsensor als eine isolierte und praktische Vorrichtung zum Messen des Stroms, der durch ein Kabel wie ein Wechselstromkabel oder ein nichtmetallisch ummanteltes Kabel fließt. Informationen über die Größe und / oder Phasen der durch die Leiter fließenden Ströme und / oder Spannungen an den Leitern werden erhalten, indem das Magnetfeld an mehreren Umfangspositionen um das Kabel unter Verwendung mehrerer Halbleitermagnetfeldsensoren gemessen wird. Ein Verarbeitungssubsystem, das mit den Magnetfeldsensoren für mehrere Halbleiter gekoppelt ist, bestimmt Informationen über die in den Leitern des Kabels fließenden Ströme, einschließlich der Stromstärke(n) und / oder der Phasen und Anzahl der im Kabel vorhandenen Phasen, die Teil sein können eines Leistungsmesssystems, das zur Energieüberwachung und / oder zu Steuerzwecken verwendet wird.

US 2015/0233980 A1 offenbart einen Verbinder zum Anbringen an einer Stromversorgungseinheit mit einem Schaltelement und zum Verbinden mit einem Gegenstecker eines Kabelbaums, wobei der Verbinder eine Verbindungsklemme mit einem Endabschnitt, der mit einer Ausgangsklemme in einem Gehäuse der Stromversorgung verbunden ist, eine Aufnahme, die an dem Gehäuse befestigt ist und mindestens einen Teil des Verbindungsanschlusses umschließt, einen Stromsensor, der in dem Gehäuse eingeschlossen ist, um ein Magnetfeld zu erfassen, das durch einen durch den Verbindungsanschluss fließenden elektrischen Strom erzeugt wird, und eine Signalleitung zum Senden ein Ausgangssignal des Stromsensors aufweist.

EP 0 597 404 A2 offenbart ein Verfahren zur Ermittlung von Leiterströmen, das auf einer messtechnischen Erfassung vektorieller magnetischer Feldstärken im Summenmagnetfeld eines Mehrleitersystems basiert. Die einzelnen Leiterströme werden auf der Grundlage der gemessenen Feldstärken berechnet. Eine geeignete Messanordnung zur Durchführung des Verfahrens umfasst eine der Leiterzahl äquivalente Anzahl von Sensoren oder im Fall eines Drehstromsystems auch nur zwei Sensoren, die im Summen-Magnetfeld nahe am Dreileitersystem und innerhalb einer magnetischen Abschirmeinrichtung angeordnet sind und mit einer Auswerteeinrichtung verbunden sind.

EP 3 044 598 A1 offenbart, einen Stromsensor in einem Steckverbinder anzuordnen.

Weiterhin wurden Steckverbindermodularsysteme unter Verwendung eines Modulrahmens, auch als Halterahmen oder Modularrahmen bekannt, in zahlreichen Druckschriften und Veröffentlichungen offenbart, auf Messen gezeigt und befinden sich insbesondere im industriellen Umfeld in Form von Schwerlaststeckverbindern im Einsatz. Beispielsweise werden sie in den Druckschriften DE 10 2013 106 279 A1, DE 10 2012 110 907 A1, DE 10 2012 107 270 A1, DE 20 2013 103 611 U1, EP 2 510 590 A1, EP 2 510 589 A1, DE 20 2011 050 643 U1, EP 860 906 A2, DE 29 601 998 U1, EP 1 353 412 A2, DE 10 2015 104 562 A1, EP 3 067 993 A1, EP 1 026 788 A1, EP 2 979 326 A1, EP 2 917 974 A1 beschrieben. Dabei werden mehrere gleiche oder verschiedene Steckverbindermodule gemeinsam in einem Modulrahmen gehalten und in ein Steckverbindergehäuse eingebaut. Die Funktion eines dadurch gebildeten Steckverbinders ist also sehr flexibel. Es können z.B. pneumatische Module, optische Module, Module zur Übertragung elektrischer Energie und/oder elektrischer analoger und/oder digitaler Signale im Modularsystem Verwendung finden. Zunehmend übernehmen Steckverbindermodule auch mit mess- und datentechnische Aufgaben.

Es besteht ein Interesse daran, insbesondre modulare Steckverbinder dahingehend weiterzuentwickeln, dass es möglich ist, jeweils einen durch die einzelnen Kontakte des Steckverbindermoduls fließenden Strom zu messen.

Eine Schwierigkeit besteht hierbei darin, dass der geometrische Bauraum innerhalb eines Steckverbinders bzw. -moduls begrenzt ist. In der Regel liegen die elektrischen Kontakte bzw. die zughörigen Leitungen nah beieinander und ihre Magnetfelder sind somit messtechnisch schwer zu trennen. Die räumlichen Einschränkungen lassen es unpraktikabel erscheinen, für jeden der elektrischen Kontakte bzw. die entsprechende Leitung separat einen eigenen konventionellen Stromsensor vorzusehen.

Ein der vorliegenden Erfindung zugrundeliegendes Ziel ist es, Steckverbinder und insbesondere Steckverbindermodularsysteme, wie sie weiter oben diskutiert sind, in Richtung einer Verbesserung der Möglichkeiten zur Messung eines jeweiligen Stromflusses durch elektrische Kontakte oder Kontaktleitungen in dem Steckverbinder weiterzuentwickeln.

Erfindungsgemäß wird nach einem ersten Aspekt ein modularer Steckverbinder vorgeschlagen, wie er in Anspruch 1 definiert ist.

Erfindungsgemäß wird nach einem zweiten Aspekt ein Verfahren zur Messung eines jeweiligen Stromflusses durch elektrische Kontakte oder Kontaktleitungen in einem modularen Steckverbinder vorgeschlagen, wie es in Anspruch 5 definiert ist.

Ein Teil des Hintergrunds der vorliegenden Erfindung findet sich in den folgenden Überlegungen.

Der Erfindung liegt zum Einen die Erkenntnis zu Grunde, dass es durch rechnerische Mittel möglich ist, aus den Messsignalen einer geeigneten Anzahl von Magnetfeldsensoren in einem Magnetfeld, das sich durch Überlagerung von Magnetfeldern ergibt, die jeweils durch die Ströme erzeugt werden, die durch die Kontakte oder Kontaktleitungen eines Steckverbinders fließen, die einzelnen Ströme zu bestimmen. Zum Anderen wurde erkannt, dass es hierbei nicht notwendig ist, die Kombination eines Kontakts bzw. einer Kontaktleitung mit einem jeweiligen Magnetfeldsensor einzeln gegenüber der Umwelt abzuschirmen, wie dies im Stand der Technik vorgenommen wurde, da eine Abschirmung insoweit ausreichend ist, als dass ein Gebiet gegenüber äußeren Störfeldern abgeschirmt wird, in dem sich die Magnetfeldsensoren und die elektrischen Kontakte bzw. Kontaktleitungen gemeinsam befinden.

Erfindungsgemäß ist zumindest ein Teil der magnetischen Abschirmung zur Anbringung in oder an einem Halterahmen des Steckverbinders zur Aufnahme eines oder mehrerer Module des Steckverbinders ausgestaltet und/oder Teil des Halterahmens (alternativ oder ergänzend ist die Abschirmung am Gehäuse angebracht und/oder Teil des Gehäuses). Ein Halterahmen, der bei bekannten modularen Steckverbinderlösungen vornehmlich die Aufgabe der Fixierung der Module zueinander und ggf. die Aufgabe eine elektrischen Kontaktierung (z.B. PE-Kontakt) übernimmt, kann in vorteilhafter Weise zudem als Träger der magnetischen Abschirmung dienen oder gar selbst als die magnetische Abschirmung ausgeführt sein.

In einer anderen vorteilhaften Ausgestaltung eines Aspekts der Erfindung erstreckt sich der Abschirmbereich in einer Ebene quer zur Stromrichtung der jeweiligen Stromflüsse, auch wenn in hierzu verkippten Ebenen eine vergleichbare Strommessung möglich ist.

In einer anderen vorteilhaften Ausgestaltung eines Aspekts der Erfindung sind die Magnetfeldsensoren Hallelemente oder weisen Hallelemente auf. Hallelemente sind anderen Ansätzen, etwa basierend auf Spulen oder Shunts, zumindest mit Blick auf eine Platzoptimierung hinsichtlich der Möglichkeiten zur Miniaturisierung überlegen, wobei es zudem ausreichend ist, ein Hallelement in einer nicht zu großen Entfernung vom Kontakt bzw. Kontaktleitung anordnen, da ein direkter räumlicher Kontakt nicht nötig ist.

In einer anderen vorteilhaften Ausgestaltung eines Aspekts der Erfindung weist die Abschirmung einen weichmagnetischen Werkstoff, insbesondere Mu-Metall, auf oder besteht daraus.

Merkmale vorteilhafter Ausführungsformen der Erfindung sind insbesondere in den Unteransprüchen definiert, wobei weitere vorteilhafte Merkmale, Ausführungen und Ausgestaltungen für den Fachmann zudem aus den obigen Erläuterung und der folgenden Diskussion zu entnehmen sind.

Im Folgenden wird die vorliegende Erfindung anhand von in den Figuren dargestellten Ausführungsbeispielen weiter illustriert und erläutert. Hierbei zeigt
- Fig. 1: eine schematische Darstellung zur Illustration eines ersten Ausführungsbeispiels einer erfindungsgemäßen Stromsensoranordnung,
- Fig. 2: eine weitere schematische Darstellung zur Illustration des ersten Ausführungsbeispiels einer erfindungsgemäßen Stromsensoranordnung,
- Fig. 3: eine schematische Darstellung eines Halterahmens mit einer Abschirmung entsprechend dem ersten Ausführungsbeispiel,
- Fig. 4: eine schematische Darstellung eines Halterahmens mit einer Abschirmung entsprechend einem zweiten Ausführungsbeispiel,
- Fig. 5: eine schematische Darstellung eines Halterahmens mit einer Abschirmung entsprechend einem dritten Ausführungsbeispiel und
- Fig. 6: ein schematisches Ablaufdiagramm eines Ausführungsbeispiels des erfindungsgemäßen Verfahrens zur Messung eines jeweiligen Stromflusses.

In den beiliegenden Zeichnungen sowie den Erläuterungen zu diesen Zeichnungen sind einander entsprechende bzw. in Beziehung stehende Elemente - soweit zweckdienlich - mit jeweils entsprechenden oder ähnlichen Bezugszeichen gekennzeichnet, auch wenn sie in unterschiedlichen Ausführungsbeispielen zu finden sind.

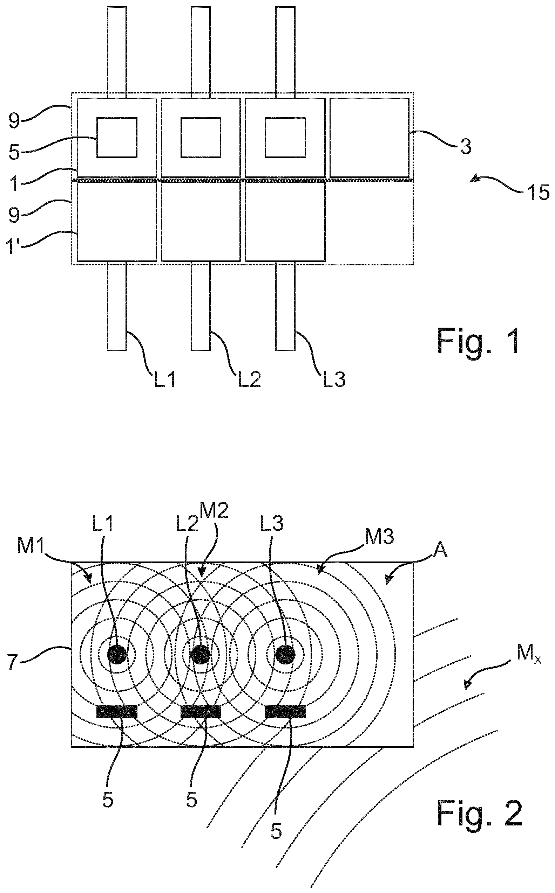

Fig. 1 zeigt eine schematische Darstellung zur Illustration eines ersten Ausführungsbeispiels einer erfindungsgemäßen Stromsensoranordnung.

Fig. 1 zeigt hierbei eine Steckverbindung mit Kontaktmodulen 1, 1', die jeweils in einem Halterahmen 9 aufgenommen sind. Die Kontaktemodule 1, 1' kontaktieren L1, L2, L3, deren Stromdurchfluss gemessen werden soll.

Die Stromsensoranordnung 15 umfasst Magnetfeldsensoren 5 und ein Rechenmodul 3, das ebenfalls in einem der Halterahmen 9 aufgenommen ist. Die Stromsensoranordnung 15 umfasst ferner eine magnetische Abschirmung aus Mu-Metall (der Übersichtlichkeit halber nicht dargestellt, siehe Fig. 2), die die Magnetfeldsensoren 5 und die Leitungen L1, L2, L3 in einer Ebene senkrecht zur Zeichenebene der Fig. 1 umschließt.

Fig. 2 zeigt eine weitere schematische Darstellung zur Illustration des ersten Ausführungsbeispiels einer erfindungsgemäßen Stromsensoranordnung.

Die Ebene, in der die magnetische Abschirmung 7 die Leitungen L1, L2, L3 und die entsprechenden Magnetfeldsensoren 5 umschließt, entspricht der Zeichnungsebene in Fig. 2.

Die durch den Stromfluss durch die Leitungen L1, L2, L3 hervorgerufenen Magnetfelder M1, M2, M3 sind schematisch durch konzentrische Kreise angedeutet, wobei diese Magnetfelder sich innerhalb der Abschirmung 7, also im Abschirmbereich A, gegenseitig überlagern. Die durch diese Überlagerung sich jeweils am Ort der Magnetfeldsensoren 5 ergebene Magnetfeldstärke kann zur Bestimmung der jeweilig zugrunde liegenden Magnetfelder und damit zum Bestimmung der Stromflüsse durch die Leitungen L1, L2, L3 genutzt werden, wobei hierbei die relativen Positionen der Magnetfeldsensoren 5 zu den Leitungen L1, L2, L3 und auch deren Positionen bekannt sein müssen.

In Fig. 2 ist zudem angedeutet, dass ein externes Störmagnetfeld Mₓ durch die Abschirmung 9 daran gehindert wird, in den Abschirmbereich A und damit zu den Magnetfeldsensoren zu gelangen. Da hierdurch weniger oder mglw. gar keine Störeinflüsse bei der Bestimmung der jeweiligen Magnetfelder M1, M2, M3 der Leitungen L1, L2, L3 zu berücksichtigen sind, sind die Messergebnisse genauer und mit weniger rechnerischem Aufbau zu erhalten.

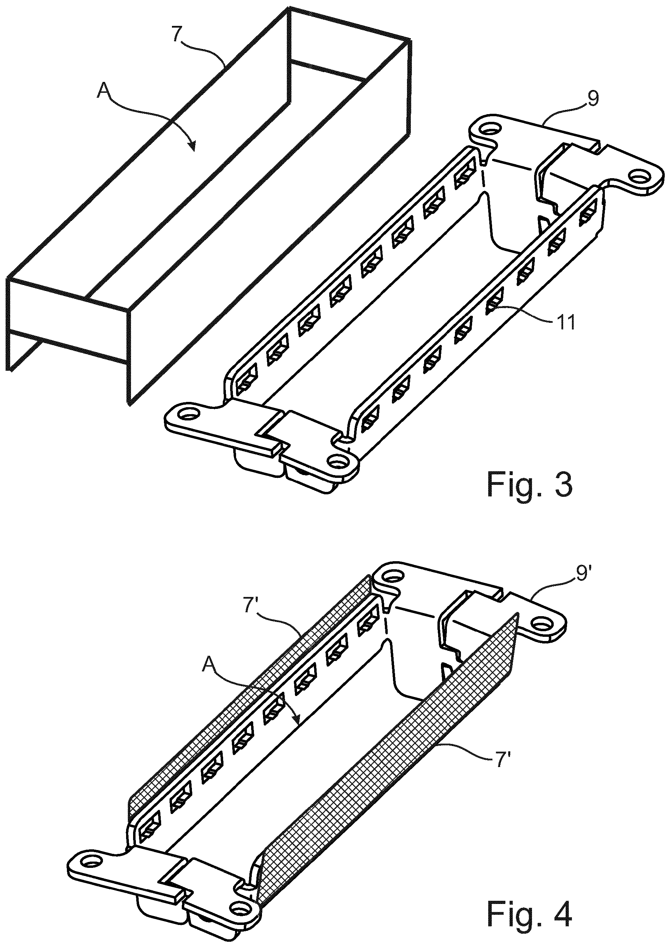

Fig. 3 zeigt eine schematische Darstellung eines Halterahmens mit einer Abschirmung entsprechend dem ersten Ausführungsbeispiel.

Der Halterahmen 9 entspricht in seinem Aufbau aus zwei Teilstücken, die miteinander über Gelenke verbunden und mittels Vor- und Rücksprüngen miteinander verschränkt sind, einem Gelenkrahmen 9, wie er in beispielsweise DE 10 2014 215 809 A1 offenbart ist. Die in den Teilstücken jeweils vorgesehenen Fenster 11 wirken mit entsprechenden Nasen von einzusetzenden Modulen (nicht dargestellt) zu deren Fixierung zusammen.

Anders als die Gelenkrahmen aus DE 10 2014 215 809 A1 ist der Rahmen 9 aus Fig. 3 zudem mit einer Abschirmung 7 versehen, die hier als separates Bauelement dargestellt ist. Der Rahmen 9 wird mit den Modulen bestückt und die Abschirmung 7 wird anschließend auf den geschlossenen Gelenkrahmen aufgesetzt und beispielsweise durch Verrastung oder ähnliches arretiert.

Fig. 4 zeigt eine schematische Darstellung eines Halterahmens mit einer Abschirmung entsprechend einem zweiten Ausführungsbeispiel.

Der in Fig. 4 gezeigte Halterahmen umfasst neben dem Gelenkrahmen 9' zwei an den Seitenflächen des Gelenkrahmens 9' beispielsweise durch Kleben befestigte Platten, die gemeinsam die magnetische Abschirmung 7' bilden.

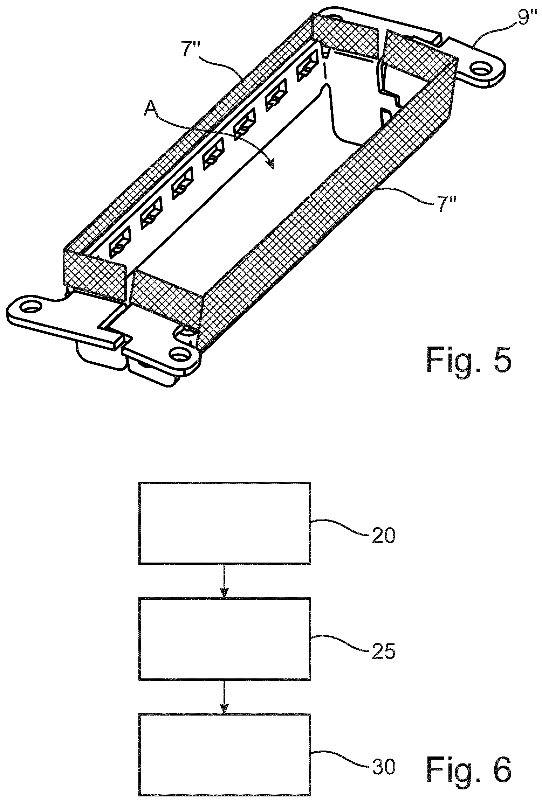

Fig. 5 zeigt eine schematische Darstellung eines Halterahmens mit einer Abschirmung entsprechend einem dritten Ausführungsbeispiel.

Der in Fig. 5 gezeigte Halterahmen umfasst wiederum neben dem Gelenkrahmen 9" zwei an den Seitenflächen des Gelenkrahmens 9" beispielsweise durch Kleben befestigte Körper, die gemeinsam die magnetische Abschirmung 7" bilden. Abweichend von dem Halterahmen aus Fig. 4 sind hier noch jeweils zwei gewinkelte Teilabschnitte vorhanden, so dass bei einem Schließen des Gelenkrahmens 9" die Teilkörper der magnetischen Abschirmung annähernd in Kontakt kommmen.

Fig. 6 zeigt ein schematisches Ablaufdiagramm eines Ausführungsbeispiels des erfindungsgemäßen Verfahrens zur Messung eines jeweiligen Stromflusses.

Das Verfahren zur Messung eines jeweiligen Stromflusses durch elektrische Kontakte oder Kontaktleitungen in einem Steckverbinder weist zunächst einen Schritt 20 des Anordnens von mehreren Magnetfeldsensoren auf, die jeweils für eine Messung einer Magnetfeldstärke im Steckverbinder ausgestaltet sind. Zudem ist ein Schritt 25 des Anordnens einer magnetischen Abschirmung zur Abschirmung eines durchgehenden Abschirmbereichs gegenüber einem äußeren Magnetfeld vorgesehen.

Das Anordnen 25 der magnetischen Abschirmung erfolgt so, dass die Abschirmung den Abschirmbereich wenigstens teilweise umschießt, wobei die mehreren Magnetfeldsensoren im Abschirmbereich angeordnet sind und die elektrischen Kontakte oder Kontaktleitungen sich gemeinsam durch den Abschirmbereich erstrecken.

Zudem umfasst das Verfahren einen (wiederholten) Schritt 30 des Bestimmens des jeweiligen Stromflusses aus Messsignalen der Magnetfeldsensoren.

Die Erfindung kann insbesondere im Zusammenhang mit einer Strommessung in einem 3-Phasen-Netz eingesetzt werden, wobei es innerhalb des Steckverbinders zu einer Überlagerung der Magnetfelder im 3-Phasen-Netz kommt. Für die Strommessung werden diese überlagerten Magnetfelder durch beispielsweise drei Hall-Sensoren in ihrer Überlagerung erfasst und an ein "Embedded System" des Steckverbinders weitergeleitet. Mittels eines Gleichungssystems werden die Überlagerungen mathematisch berechnet und um die jeweiligen Werte korrigiert.

Es ist hierbei für die Genauigkeit ausschlaggebend, dass die Hall-Sensoren vor externen Magnetfeldern, also Störungen, geschützt werden. Diese störenden Magnetfelder können z.B. durch stromführende Kabel, welche am Gehäuse verlaufen verursacht werden.

Eine solche Stromsensoranordnung, wie sie oben beschrieben ist, wird beispielsweise zunächst in einen Gelenkrahmen und anschließend in das Gehäuse des Steckverbinders montiert. Konventionelle Gehäuse oder Gelenkrahmen können die Sensoren der Stromsensoranordnung nicht gegenüber externen Magnetfeldern abschirmen.

Zur Abschirmung von Magnetfeldern eignen sich weichmagnetisch Werkstoffe besonders gut. Durch derartige ferromagnetische Materialien mit einer hohen Permeabilität kann der Verlauf der magnetischen Feldlinien beeinflussen werden.

Als Träger für dieses weichmagnetische Material fungiert vorzugsweise der Gelenkrahmen. Die Abschirmung kann hierbei unterschiedliche Formen und Arretierungsmöglichkeiten haben.

Bei einer Strommessung in einem Steckverbinder erlaubt die vorliegende Erfindung eine hohe Messgenauigkeit, da die beispielsweise verwendeten Hallelement vor externen Magnetfelder geschützt werden. Hierbei wird vorzugsweise eine magnetische Abschirmung in Form eines weichmagnetischen Material genutzt, welche um bzw. an den Gelenkrahmen des Steckverbinders befestigt ist. Hierbei werden bei optimaler Auslegung der gesamte Einsatz des Steckverbinders und alle Sensoren gleichzeitig vollständig gegenüber äußeren magnetischen Einflüssen abgeschirmt.

Bei herkömmlichen Ansätzen, bei denen jeweils einzelnen Leitungen mit eigenen, dedizierten Magnetfeldsensoren mit eigener Abschirmung versehen werden, steigt mit der Leitungszahl die Komplexität der Konstruktion (Verschachtelungen der einzelnen Komponenten, Einhaltung der Luft- und Kriechstrecken), so dass der Herstellprozess der einzelnen Komponenten komplex und teuer wird (z.B. Umspritzen von Abschirmmaterial)

Die gleichzeitige Abschirmung aller Sensoren im Isolierkörper (z.B. im 3-Phasen Netz) und die Berücksichtigung der gegenseitigen Beeinflussung der Magnetfelder (z.B. im 3-Phasen Netz), die mathematisch berechnet und korrigiert wird, erlaubt eine genaue Bestimmung des jeweilig fließenden Stroms, wobei der Herstell- und Montageprozess vergleichsweise einfach bleibt und eine kompaktere Bauweise möglich wird.

### Bezugszeichenliste

- 1, 1': Kontaktmodul
- 3: Rechenmodul
- 5: Magnetfeldsensor
- 7, 7', 7": Abschirmung
- 9, 9', 9": Gelenkrahmen
- 11: Fenster
- 15: Stromsensoranordnung
- 20: Anordnen von Magnetfeldsensoren
- 25: Anordnen einer magnetischen Abschirmung
- 30: Bestimmen eines Stromflusses
- A: Abschirmbereich
- L1, L2, L3: Leiter
- Mₓ: Störmagnetfeld
- M1, M2, M3: Magnetfeld

## Patentansprüche

1. Modularer Steckverbinder, umfassend
mehrere gleichartige und/oder unterschiedliche Module (1, 1'), die jeweils wenigstens einen elektrischen Kontakt oder wenigstens eine Kontaktleitung (L1, L2, L3) aufweisen, und
einen Halterahmen (9, 9', 9") zur Aufnahme der Module (1, 1'), **dadurch gekennzeichnet, dass** der modulare Steckverbinder weiterhin umfasst:
eine Stromsensoranordnung (15) zur Messung eines jeweiligen Stromflusses durch die elektrischen Kontakte oder Kontaktleitungen (L1, L2, L3), mit:
mehreren Magnetfeldsensoren (5), die jeweils für eine Messung einer Magnetfeldstärke im Steckverbinder ausgestaltet sind,
einer magnetischen Abschirmung (7, 7', 7"), die einen durchgehenden Abschirmbereich (A) zur Abschirmung gegenüber einem äußeren Magnetfeld (Mₓ) wenigstens teilweise umschließt, und
einem mit den Magnetfeldsensoren (5) verbundenen Rechenmodul (3),
wobei die mehreren Magnetfeldsensoren (5) im Abschirmbereich (A) angeordnet sind und sich die elektrischen Kontakte oder Kontaktleitungen (L1, L2, L3) gemeinsam durch den Abschirmbereich (A) erstrecken,
zumindest ein Teil der magnetischen Abschirmung (7, 7', 7") in oder an dem Halterahmen (9, 9', 9") angebracht ist, Teil des Halterahmens (9, 9', 9") ist, in oder an einem Gehäuse des Steckverbinders angebracht ist und/oder Teil des Gehäuses ist,
der Halterahmen (9, 9', 9") die mehreren Magnetfeldsensoren (5) aufnimmt, und
das Rechenmodul (3) auf Basis relativer Positionen der Magnetfeldsensoren (5) zu den elektrischen Kontakten oder Kontaktleitungen (L1, L2, L3) und deren Positionen zur Bestimmung eines jeweiligen Stromflusses durch jeden einzelnen elektrischen Kontakt bzw. jede einzelne Kontaktleitung (L1, L2, L3) aus den Messsignalen der mehreren Magnetfeldsensoren (5) ausgestaltet ist.

2. Modularer Steckverbinder nach Anspruch 1, wobei sich der Abschirmbereich (A) in einer Ebene quer zur Stromrichtung der jeweiligen Stromflüsse erstreckt.

3. Modularer Steckverbinder nach einem der vorstehenden Ansprüche, wobei die Magnetfeldsensoren (5) Hallelemente (5) sind oder aufweisen.

4. Modularer Steckverbinder nach einem der vorstehenden Ansprüche, wobei die Abschirmung (7, 7', 7") einen weichmagnetischen Werkstoff, insbesondere Mu-Metall, aufweist oder daraus besteht.

5. Verfahren zur Messung eines jeweiligen Stromflusses durch elektrische Kontakte oder Kontaktleitungen (L1, L2, L3) in einem modularen Steckverbinder,
wobei der modularen Steckverbinder mehrere gleichartige und/oder unterschiedliche Module (1, 1'), die jeweils wenigstens einen elektrischen Kontakt oder wenigstens eine Kontaktleitung (L1, L2, L3) aufweisen, einen Halterahmen (9, 9', 9") zur Aufnahme der Module (1, 1'), und eine Stromsensoranordnung (15) zur Messung eines jeweiligen Stromflusses durch die elektrischen Kontakte oder Kontaktleitungen (L1, L2, L3) mit mehreren Magnetfeldsensoren (5), die jeweils für eine Messung einer Magnetfeldstärke im Steckverbinder ausgestaltet sind, einer magnetischen Abschirmung (7, 7', 7"), die einen durchgehenden Abschirmbereich (A) zur Abschirmung gegenüber einem äußeren Magnetfeld (Mₓ) wenigstens teilweise umschließt, und einem mit den Magnetfeldsensoren (5) verbundenen Rechenmodul (3) umfasst, wobei zumindest ein Teil der magnetischen Abschirmung (7, 7', 7") in oder an dem Halterahmen (9, 9', 9") angebracht ist, Teil des Halterahmens (9, 9', 9") ist, in oder an einem Gehäuse des Steckverbinders angebracht ist und/oder Teil des Gehäuses ist, und der Halterahmen (9, 9', 9") die mehreren Magnetfeldsensoren (5) aufnimmt
und das Verfahren die Schritte umfasst:
Anordnen (20) der mehreren Magnetfeldsensoren (5) und
Anordnen (25) der magnetischen Abschirmung (7, 7', 7") zur Abschirmung eines durchgehenden Abschirmbereichs (A) gegenüber einem äußeren Magnetfeld (Mₓ),
wobei das Anordnen (25) der magnetischen Abschirmung (7, 7', 7") so erfolgt, dass die Abschirmung (7, 7', 7") den Abschirmbereich (A) wenigstens teilweise umschießt, dass die mehreren Magnetfeldsensoren (5) im Abschirmbereich (A) angeordnet sind und dass sich die elektrischen Kontakte oder Kontaktleitungen (L1, L2, L3) gemeinsam durch den Abschirmbereich (A) erstrecken,
**gekennzeichnet durch** einen weiteren Schritt
des Bestimmens (30) des jeweiligen Stromflusses durch jeden einzelnen elektrischen Kontakt bzw. jede einzelne Kontaktleitung (L1, L2, L3) aus den Messsignalen der mehren Magnetfeldsensoren (5) auf Basis relativer Positionen der Magnetfeldsensoren (5) zu den elektrischen Kontakten oder Kontaktleitungen (L1, L2, L3) und deren Positionen.

## Claims

1. Modular plug connector comprising
a plurality of identical and/or different modules (1, 1'), each of which has at least one electrical contact or at least one contact lead (L1, L2, L3), and
a holding frame (9, 9', 9") for receiving the modules (1, 1'),
**characterized in that** the modular plug connector further comprises:
a current sensor arrangement (15) for measuring a respective current flow through the electrical contacts or contact leads (L1, L2, L3), comprising:
a plurality of magnetic field sensors (5) each adapted for measuring a magnetic field strength in the plug connector,
a magnetic shield (7, 7', 7") that at least partially encloses a continuous shielded area (A) in order to shield it against an external magnetic field (Mₓ), and
a calculation module (3) connected to the magnetic field sensors (5) ,
wherein the plurality of magnetic field sensors (5) are arranged in the shielded area (A) and the electrical contacts or contact leads (L1, L2, L3) extend collectively through the shielded area (A),
at least part of the magnetic shield (7, 7', 7") is attached in or on the holding frame (9, 9', 9"), is part of the holding frame (9, 9', 9"), is attached in or on a housing of the plug connector and/or is part of the housing,
the holding frame (9, 9', 9") accommodates the plurality of magnetic field sensors (5), and
the calculation module (3) is configured to determine a respective current flow through each individual electrical contact or contact lead (L1, L2, L3) from the measurement signals of the plurality of magnetic field sensors (5) based on positions of the magnetic field sensors (5) relative to the electrical contacts or contact leads (L1, L2, L3) and their positions.

2. Modular plug connector according to claim 1, wherein the shielded area (A) extends in a plane transverse to the direction of the respective current flows.

3. Modular plug connector according to one of the preceding claims, wherein the magnetic field sensors (5) are or have Hall elements (5).

4. Modular plug connector according to one of the preceding claims, wherein the shield (7, 7', 7") includes or consists of a soft magnetic material, in particular mu-metal.

5. Method for measuring a respective current flow through electrical contacts or contact leads (L1, L2, L3) in a modular connector,
wherein the modular plug connector comprises a plurality of identical and/or different modules (1, 1'), each of which has at least one electrical contact or at least one contact lead (L1, L2, L3), a holding frame (9, 9', 9") for receiving the modules (1, 1'), and a current sensor arrangement (15) for measuring a respective current flow through the electrical contacts or contact leads (L1, L2, L3) with a plurality of magnetic field sensors (5), each of which is adapted to measure a magnetic field strength in the plug connector, a magnetic shield (7, 7', 7") that at least partially encloses a continuous shielded area (A) in order to shield it against an external magnetic field (Mₓ), and a calculation module (3) connected to the magnetic field sensors (5), wherein at least a part of the magnetic shield (7, 7', 7") is attached in or on the holding frame (9, 9', 9"), is part of the holding frame (9, 9', 9"), is attached in or on a housing of the connector and/or is part of the housing, and the holding frame (9, 9', 9") accommodates the plurality of magnetic field sensors (5)
and the method comprises the steps of:
arranging (20) the plurality of magnetic field sensors (5) and
arranging (25) the magnetic shield (7, 7', 7") to shield a continuous shielded area (A) from an external magnetic field (Mₓ ),
wherein the arranging (25) of the magnetic shield (7, 7', 7") is carried out in such a way that the shield (7, 7', 7") at least partially encloses the shielded area (A), that the multiple magnetic field sensors (5) are arranged in the shielded area (A), and that the electrical contacts or contact leads (L1, L2, L3) extend collectively through the shielded area (A),
**characterized by** a further step
of determining (30) the respective current flow through each individual electrical contact or contact lead (L1, L2, L3) from the measurement signals of the multiple magnetic field sensors (5) based on positions of the magnetic field sensors (5) relative to the electrical contacts or contact leads (L1, L2, L3) and their positions.

## Revendications

1. Connecteur modulaire, comprenant
plusieurs modules (1, 1'), identiques et/ou différents, qui présentent chacun au moins un contact électrique ou au moins un conducteur de contact (L1, L2, L3), et
un cadre de maintien (9, 9', 9") pour recevoir les modules (1, 1'), **caractérisé en ce que** le connecteur modulaire comprend par ailleurs :
un ensemble capteur de courant (15) pour mesurer un flux de courant respectif à travers les contacts électriques ou conducteurs de contact (L1, L2, L3), avec :
plusieurs capteurs de champ magnétique (5), qui sont chacun configurés pour une mesure d'une intensité de champ magnétique dans le connecteur,
un blindage magnétique (7, 7', 7") qui entoure au moins en partie une zone de blindage (A) continue pour le blindage par rapport à un champ magnétique extérieure (Mₓ), et
un module de calcul (3) relié aux capteurs de champ magnétique (5),
dans lequel les plusieurs capteurs de champ magnétique (5) sont disposés dans la zone de blindage (A) et les contacts électriques ou conducteurs de contact (L1, L2, L3) s'étendent ensemble à travers la zone de blindage (A),
au moins une partie du blindage magnétique (7, 7', 7") est installée dans ou sur le cadre de maintien (9, 9', 9"), fait partie du cadre de maintien (9, 9', 9"), est montée dans ou sur un boîtier du connecteur et/ou fait partie du boîtier,
le cadre de maintien (9, 9', 9") reçoit les plusieurs capteurs de champ magnétique (5), et
le module de calcul (3) est configuré pour, sur la base de positions relatives des capteurs de champ magnétique (5) par rapport aux contacts électriques ou aux conducteurs de contact (L1, L2, L3) et de leurs positions, déterminer un flux de courant respectif à travers chaque contact électrique individuel ou chaque conducteur de contact individuel (L1, L2, L3) à partir des signaux de mesure des plusieurs capteurs de champ magnétique (5).

2. Connecteur modulaire selon la revendication 1, dans lequel la zone de blindage (A) s'étend dans un plan de manière transversale à la direction de courant des flux de courant respectifs.

3. Connecteur modulaire selon l'une quelconque des revendications précédentes, dans lequel les capteurs de champ magnétique (5) sont ou présentent des éléments à effet Hall (5).

4. Connecteur modulaire selon l'une quelconque des revendications précédentes, dans lequel le blindage (7, 7', 7") présente ou est constitué d'un matériau magnétique doux, en particulier de métal Mu.

5. Procédé de mesure d'un flux de courant respectif à travers des contacts électriques ou des conducteurs de contact (L1, L2, L3) dans un connecteur modulaire,
dans lequel le connecteur modulaire comprend plusieurs modules (1, 1'), identiques et/ou différents, qui présentent chacun au moins un contact électrique ou au moins un conducteur de contact (L1, L2, L3), un cadre de maintien (9, 9', 9") pour loger les modules (1, 1'), et un ensemble de capteur de courant (15) pour mesurer un flux de courant respectif à travers les contacts électriques ou les conducteurs de contact (L1, L2, L3) avec plusieurs capteurs de champ magnétique (5), qui sont configurés pour mesurer une intensité de champ magnétique dans le connecteur, un blindage magnétique (7, 7', 7"), qui entoure au moins en partie une zone de blindage (A) continue, pour se protéger d'un champ magnétique extérieur (Mₓ), et un module de calcul (3) relié aux capteurs de champ magnétique (5), dans lequel au moins une partie du blindage magnétique (7, 7', 7") est installée dans ou sur le cadre de maintien (9, 9', 9"), fait partie du cadre de maintien (9, 9', 9"), est installée dans ou sur un boîtier du connecteur et/ou fait partie du boîtier, et le cadre de maintien (9, 9', 9") loge les plusieurs capteurs de champ magnétique (5),
et le procédé comprend les étapes :
de disposition (20) des plusieurs capteurs de champ magnétique (5) et
de disposition (25) du blindage magnétique (7, 7', 7") pour protéger une zone de blindage (A) continue contre un champ magnétique extérieur (Mₓ),
dans lequel la disposition (25) du blindage magnétique (7, 7', 7") est effectuée de telle sorte que le blindage (7, 7', 7") entoure au moins en partie la zone de blindage (A), que les plusieurs capteurs de champ magnétique (5) sont disposés dans la zone de blindage (A) et que les contacts électriques ou les conducteurs de contact (L1, L2, L3) s'étendent ensemble à travers la zone de blindage (A),
**caractérisé par** une étape supplémentaire
de détermination (30) du flux de courant respectif à travers chaque contact électrique individuel ou chaque ligne de conducteur individuel (L1, L2, L3) à partir des signaux de mesure des plusieurs capteurs de champ magnétique (5) sur la base de positions relatives des capteurs de champ magnétique (5) par rapport aux contacts électriques ou conducteurs de contact (L1, L2, L3) et de leurs positions.
